# EUROPEAN PATENT APPLICATION

(11) **EP 4 435 831 A1**
(43) Date of publication of application: **25.09.2024**
(21) Application number: 22895892.2
(22) Date of filing: 28.10.2022
(51) Int. Cl.: H01J 37/32, H01L 21/67

(54) **SUBSTRATE TREATMENT APPARATUS AND SUBSTRATE TREATMENT METHOD**

(30) Priority: 18.11.2021 KR 20210159175
(71) Applicant: PSK Inc., Hwaseong-si, Gyeonggi-do 18849 (KR)
(72) Inventor: YOON, Sung Jin, Hwaseong-si Gyeonggi-do 18849 (KR); SEO, Hyung Seok, Hwaseong-si Gyeonggi-do 18849 (KR); PARK, Jong Woo, Hwaseong-si Gyeonggi-do 18849 (KR); SEO, Hyo Jeong, Hwaseong-si Gyeonggi-do 18849 (KR); KIM, Beom Seok, Hwaseong-si Gyeonggi-do 18849 (KR)
(74) Representative: HGF
(86) International application number: PCT/KR2022/016640
(87) International publication number: WO 2023/090685

(57) **Abstract**

The present invention provides an apparatus for treating a substrate. The apparatus for treating a substrate may comprise: a process treatment part which provides a treatment space where a substrate is treated; and a plasma source which generates plasma from process gas, wherein: the plasma source includes an antenna which has a coil wound in multiple turns, and a power application unit which applies high-frequency power to the coil; a first ground line is connected to one end of the coil and a second ground line is connected to the other end of the coil; and the power application unit is connected to the coil so as to apply high-frequency power directly to the coil at a position between one end and the other end of the coil.

## Description

### [Technical Field]

The present invention relates to a substrate processing apparatus and a substrate processing method, and more particularly to a substrate processing apparatus and a substrate processing method that process a substrate by using plasma.

### [Background Art]

Plasma is an ionized gas state composed of ions, radicals, electrons, and the like. Plasma is generated by very high temperatures, strong electric fields, or RF Electromagnetic Fields. The semiconductor device manufacturing process includes an ashing or etching process that removes a thin film on a substrate by using plasma. The ashing or etching process is performed by ion and radical particles contained in the plasma colliding or reacting with a film on the substrate.

Among these plasma devices, Inductively Coupled Plasma (ICP) devices convert the source material into plasma by using an induced electric field induced by a coil-shaped antenna. The ICP devices are divided into single-output antennas and multi-output antennas based on the number of output terminals in which a power source is connected to an antenna, and are divided into single-coil antennas and multi-coil antennas based on the number of coils provided in the antenna.

The ICP device with a single output antenna structure may control the strength of the magnetic field, but it is difficult to control the distribution of the magnetic field in the space where the substrate is processed. As a result, it is problematic to control the distribution of the plasma in the processing space to ensure the uniformity of the process.

Furthermore, the ICP device having a plurality of coil antenna structures and having an output terminal connected to each coil may control the distribution of plasma by independently adjusting the magnetic field generated by each coil. However, a separate device capable of controlling the plurality of output terminals is required. This causes the problem of structural complexity of the plasma device.

### [Technical Problem]

An object of the present invention is to provide a substrate processing apparatus and substrate processing method capable of efficiently adjusting the intensity of plasma generated from a plasma source.

Another object of the present invention is to provide a substrate processing apparatus and substrate processing method capable of efficiently distributing the distribution of plasma generated from a plasma source.

Another object of the present invention is to provide a substrate processing apparatus and substrate processing method that provide an antenna having a single output terminal and consist of a single coil.

The problem to be solved by the present invention is not limited to the above-mentioned problems, and the problems not mentioned will be clearly understood by those skilled in the art from the present specification and the accompanying drawings.

### [Technical Solution]

An exemplary embodiment of the present invention provides an apparatus for processing a substrate, the apparatus including: a process processing unit providing a processing space in which a substrate is processed; and a plasma source for generating plasma from process gas, in which the plasma source includes: an antenna including a coil wound with a plurality of turns; and a power application unit for applying high frequency power to the coil, and a first ground line is connected to one end of the coil, a second ground line is connected to the other end of the coil, and the power application unit is connected to the coil to apply high frequency power directly to the coil at a location between the one end of the coil and the other end of the coil.

According to the exemplary embodiment, the first ground line or the second ground line may be provided with a capacitor.

According to the exemplary embodiment, the capacitor may be a variable capacitor, the apparatus may further include a controller controlling the capacitor, and the controller may control the capacitor to adjust a ratio of power distributed to the first ground line and the second ground line by changing capacitance of the capacitor.

According to the exemplary embodiment, the apparatus may further include a plasma chamber having a generating space in which the plasma is generated above the process processing unit, in which the antenna may include the coil wound around the plasma chamber with a plurality of turns on an external portion of the plasma chamber, and the coil may be wound around the plasma chamber with an odd number of turns.

According to the exemplary embodiment, the coil may be provided in a circular shape when viewed from above, and the one end of the coil and the other end of the coil may be provided in an overlapping position when viewed from above.

According to the exemplary embodiment, the power application unit may include a power source generating the high frequency power and a power line delivering the high frequency power generated by the power source, the power line may be connected at an intermediate position between the one end of the coil and the other end of the coil, and when viewed from above, a virtual straight line connecting a first ground terminal in which the first ground line may be connected to the coil and the power application terminal in which the power line is connected to the coil passes through a center of the coil.

According to the exemplary embodiment, the antenna may be located above the process processing unit, and may be provided in a spiral shape on a plane.

According to the exemplary embodiment, a virtual straight line connecting one end of the coil to the other end of the coil may pass through a center of the coil.

According to the exemplary embodiment, the power application unit may include a power source generating the high frequency power and a power line delivering the high frequency power generated by the power source, and the power line may be connected between one end of the coil and the other end of the coil.

According to the exemplary embodiment, the antenna may be located to face a support unit supporting a substrate in the processing space, when viewed from above.

According to the exemplary embodiment, the capacitor may be provided as a fixed capacitor.

Another exemplary embodiment of the present invention provides a method of processing a substrate, the method including: generating plasma from process gas by applying a high frequency current directly to a coil through a power application terminal located between one end and the other end of the coil wound with a plurality of turns, in which the high frequency current is divided into a first current from the power application terminal toward the one end of the coil and a second current from the power application terminal toward the other end of the coil, and a distribution ratio of the first current and the second current is determined by a capacitor provided at one end of the coil or at the other end of the coil.

According to the exemplary embodiment, a current ratio of the first current and the second current may be adjusted by changing capacitance of the capacitor.

According to the exemplary embodiment, the coil may be wound around the plasma chamber with an odd number of turns and wrapped around the plasma chamber on an external portion of the plasma chamber having a generating space in which the plasma is generated, and be provided in a circular shape when viewed from above, the one end of the coil and the other end of the coil may be provided in an overlapping position, when viewed from above, and the power application terminal may be located in an intermediate position between the one end of the coil and the other end of the coil

According to the exemplary embodiment, when viewed from above, a half region based on an arbitrary straight line passing through a center of a substrate may have a plasma density of a first magnitude, and the remaining region of the half region may have a plasma density of a second magnitude.

According to the exemplary embodiment, the coil may be provided in a spiral shape in a plane, and a virtual straight line connecting the one end of the coil with the other end of the coil may pass through a center of the coil.

According to the exemplary embodiment, a location where the power application terminal is connected to the coil may be changed.

According to the exemplary embodiment, in a region opposite the one end of the coil from the power application terminal, a plasma density of a first magnitude may be formed from the first current, and in a region opposite the other end of the coil from the power application terminal, a plasma density of a second magnitude may be formed from the second current.

### [Advantageous Effects]

According to the exemplary embodiment of the present invention, it is possible to efficiently adjust the intensity of the plasma generated from the plasma source.

Furthermore, according to the exemplary embodiment of the present invention, it is possible to efficiently distribute the plasma generated by the plasma source.

Furthermore, according to the exemplary embodiment of the present invention, it is possible to provide an antenna including a single coil with a single output terminal.

The effect of the present invention is not limited to the foregoing effects, and the not-mentioned effects will be clearly understood by those skilled in the art from the present specification and the accompanying drawings.

### [Description of Drawings]

FIG. 1 is a diagram schematically illustrating a substrate processing apparatus according to an exemplary embodiment of the present invention.
FIG. 2 is a diagram schematically illustrating a process chamber performing a plasma treatment process among process chambers of the substrate processing apparatus of FIG. 1 according to the exemplary embodiment.
FIG. 3 is a diagram schematically illustrating a plasma source of FIG. 2.
FIG. 4 is a diagram schematically illustrating the plasma source of FIG. 2 from a top view.
FIG. 5 is a diagram schematically illustrating the plasma source of FIG. 2 from a bottom view.
FIG. 6 is a diagram schematically illustrating a process chamber performs a plasma treatment process among the process chambers of the substrate processing apparatus of FIG. 1 according to another exemplary embodiment.
FIG. 7 is a perspective view schematically illustrating the plasma source of FIG. 6.
FIG. 8 is a diagram schematically illustrating a magnetic field distribution inside the chamber according to a value of a capacitor of FIG. 6.

### [Best Mode]

Hereinafter, an exemplary embodiment of the present invention will be described in more detail with reference to the accompanying drawings. An exemplary embodiment of the present invention may be modified in various forms, and the scope of the present invention should not be construed as being limited by the exemplary embodiment described below. The present exemplary embodiment is provided to more completely explain the present invention to those skilled in the art. Therefore, the shapes of components in the drawings are exaggerated to emphasize a clearer description.

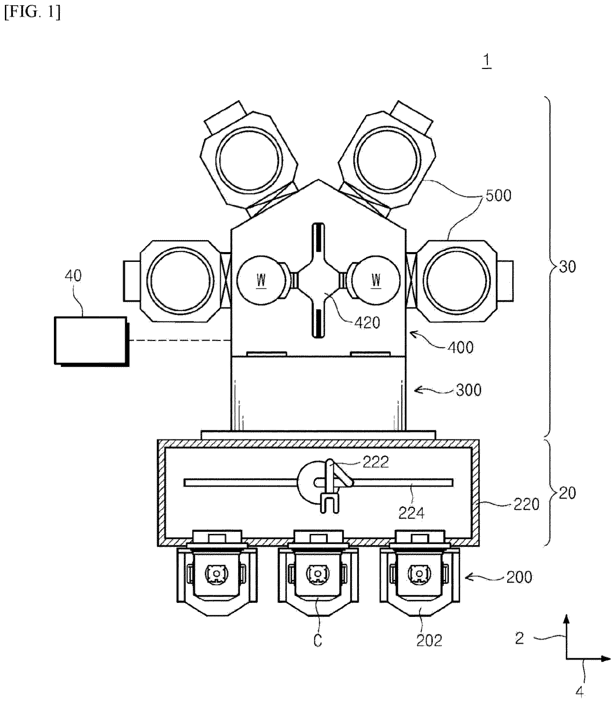

Hereinafter, an exemplary embodiment of the present invention will be described in detail with reference to FIGS. 1 to 8.

FIG. 1 is a diagram schematically illustrating a substrate processing apparatus of the present invention. Referring to FIG. 1, a substrate processing apparatus 1 includes an Equipment Front End Module (EFEM) 20 and a processing module 30. The EFEM 20 and the processing module 30 are disposed in one direction.

The equipment front end module 20 includes a load port 10 and a transfer frame 220. The load port 200 is disposed at the front of the equipment front end module 20 in a first direction 2. The load port 10 includes a plurality of support parts 202. Each support part 202 is arranged in a row in a second direction 4, on which a substrate W to be provided to the process and a carrier C (for example, cassette, or FOUP) in which the completely processed substrate W is accommodated are seated. In the carrier C, the substrate W to be provided to the process and the substrate W that has been completely processed are accommodated. The transfer frame 220 is disposed between the load port 200 and the processing module 30. The transfer frame 220 includes a first transfer robot 222 disposed therein and transferring the substrate W between the load port 200 and the processing module 30. The first transfer robot 222 moves along a transfer rail 224 provided in the second direction 4 to transfer the substrate W between the carrier C and the processing module 30.

The processing module30 includes a load lock chamber 300, a transfer chamber 400, and a process chamber 500.

The load lock chamber 300 is disposed to be adjacent to the transfer frame 220. In one example, the load lock chamber 300 may be disposed between the transfer chamber 400 and the equipment front end module 20. The load lock chamber 300 provides a waiting area for substrates W to be provided to the process before they are transferred to the process chamber 500, or for substrates W that have completed process processing before they are transferred to the equipment front end module 20.

The transfer chamber 400 is disposed to be adjacent to the load lock chamber 300. The transfer chamber 400 has a polygonal body when viewed from above. In one example, the transfer chamber 400 may have a pentagonal body when viewed from above. On the outer side of the body, a load lock chamber 300 and a plurality of process chambers 500 are disposed along the circumstance of the body. A passage (not illustrated) through which the substrate W enters and exists is formed on each sidewall of the body, and the passage connects the transfer chamber 50 and the load lock chamber 300 or the process chambers 500. Each passage is provided with a door (not illustrated) which opens/closes the passage to seal the interior.

In the interior space of the transfer chamber 400, a second transfer robot 420 is arranged to transfer the substrate W between the load lock chamber 300 and the process chamber 500. The second transfer robot 420 transfers the unprocessed substrate W waiting in the load lock chamber 300 to the process chamber 500, or transfers the processed substrate W to the load lock chamber 300. Then, the substrate W is transferred between the process chambers 500 to sequentially provide the substrate W to the plurality of process chambers 500. In one example, as illustrated in FIG. 1, when the transfer chamber 400 has a pentagonal body, each load lock chamber 300 is disposed on the sidewall adjacent to the equipment front end module 20, and the process chambers 500 are sequentially disposed on the remaining sidewalls. The shape of the transfer chamber 400 is not limited to, and may be provided in various forms depending on the process module required.

The process chambers 500 are disposed along the circumference of the transfer chamber 400. The plurality of process chambers 500 may be provided. Within each process chamber 500, a process processing is performed on the substrate W. The process chamber 500 receives the substrate W from the second transfer robot 420, processes the substrate W, and provides the processed substrate W to the second transfer robot 420. The process processing performed in the respective process chambers 500 may be different from each other.

The controller 40 may control the substrate processing apparatus 1. The controller 40 may include a process controller formed of a microprocessor (computer) that executes the control of the substrate processing apparatus 1, a user interface formed of a keyboard in which an operator performs a command input operation or the like in order to manage the substrate processing apparatus 1, a display for visualizing and displaying an operation situation of the substrate processing apparatus 1, and the like, and a storage unit storing a control program for executing the process executed in the substrate processing apparatus 1 under the control of the process controller or a program, that is, a treating recipe, for executing the process in each component according to various data and treating conditions. Further, the user interface and the storage unit may be connected to the process controller. The treating recipe may be stored in a storage medium in the storage unit, and the storage medium may be a hard disk, and may also be a portable disk, such as a CD-ROM or a DVD, or a semiconductor memory, such as a flash memory.

The controller 30 may control the substrate processing apparatus 1 so as to perform a substrate processing method described below. For example, the controller 40 may control the configurations provided to the process chamber 500 to perform the substrate processing method described below.

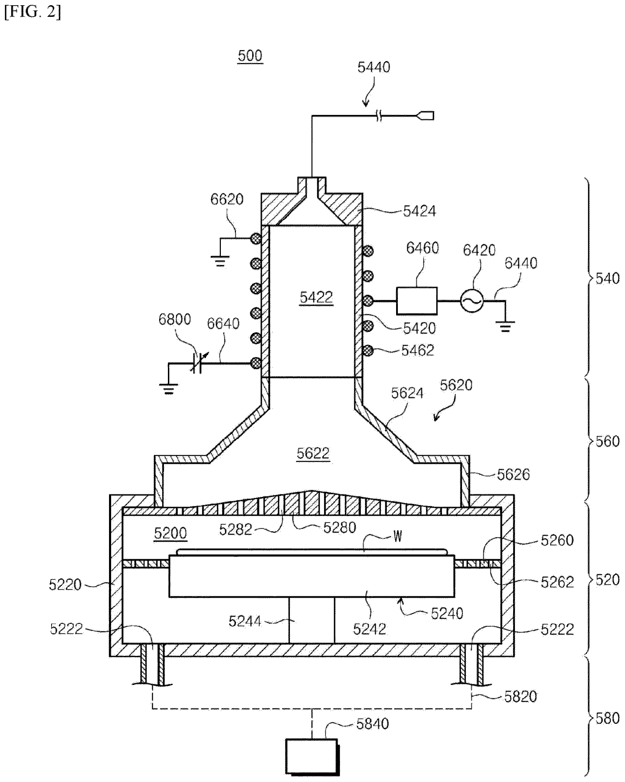

FIG. 2 is a diagram schematically illustrating the process chamber performing a plasma treatment process among the process chambers of the substrate processing apparatus of FIG. 1 according to the exemplary embodiment. Hereinafter, a process chamber 500 performing a plasma treatment process is described in detail.

Referring to FIG. 2, the process chamber 500 performs a predetermined process on the substrate W by using plasma. In one example, a thin film on the substrate W may be etched or ashed. The thin film may be various types of films, such as a polysilicon film, an oxide film, or a silicon nitride film. Optionally, the thin film may be a natural oxide film or a chemically generated oxide film.

The process chamber 500 may include a process processing unit 520, a plasma generation unit 540, a diffusion unit 560, and an exhaust unit 580.

The process processing unit 520 provides a processing space 5200 where the substrate W is placed and where processing is performed on the substrate W. The plasma generation unit 540, which is described later, generates plasma by discharging process gas, and supplies the generated plasma to the processing space 5200 of the process processing unit 520. Process gas that remains inside the process processing unit 520 and/or reaction by-products generated in the process of processing the substrate W are discharged to the outside of the process chamber 500 through the exhaust unit 580, which will be described later. This allows the pressure within the process processing section 520 to be maintained at a set pressure.

The process processing unit 520 may include a housing 5220, a support unit 5240, an exhaust baffle 5260, and a baffle 5280.

The interior of the housing 5220 may be provided with a processing space 5200 for performing a substrate processing process. An outer wall of the housing 5220 may be provided as a conductor. In one example, the outer wall of the housing 5220 may be provided of a metal material including aluminum. The housing 5220 may be open at the top, and an opening (not illustrated) may be formed in the side wall. The substrate W enters and exits the interior of the housing 110 through the opening. The opening (not illustrated) may be opened and closed by an opening/closing member, such as a door (not illustrated). Additionally, an exhaust hole 5222 is formed in a bottom surface of the housing 5220.

The exhaust hole 5222 allows process gases and/or byproducts flowing within the processing space 5200 to be exhausted to the outside of the processing space 5200. The exhaust hole 5222 may be connected with the configurations including the exhaust unit 580 described later.

The support unit 5240 supports the substrate W in the processing space 5200. The support unit 5240 may include a support plate 5242 and a support shaft 5244. The support plate 5242 may be connected to an external power source. The support plate 5242 may generate static electricity by power applied from the external power source. The electrostatic force of the generated static electricity may hold the substrate W to the support unit 5240.

The support shaft 5244 may move a target object. For example, the support shaft 5244 may move the substrate W in an upward or downward direction. In one example, the support shaft 5244 may be coupled with the support plate 5244 and may raise and lower the support plate 5242 to move the substrate W up and down.

The exhaust baffle 5260 uniformly exhausts plasma from the processing space 5200 for each region. When viewed from above, the exhaust baffle 300 has an annular ring shape. The exhaust baffle 5260 may be positioned between the inner wall of the housing 5220 and the support unit 5240 within the processing space 5200. A plurality of exhaust holes 5262 is formed in the exhaust baffle 5260. The exhaust holes 5262 may be provided to face in an upward or downward direction. The exhaust holes 5262 may be provided as holes extending from a top end to a bottom end of the exhaust baffle 5260. The exhaust holes 5262 may be arranged to be spaced apart from each other along the circumferential direction of the exhaust baffle 5260.

The baffle 5280 may be disposed between the process processing unit 520 and the plasma generation unit 540. Further, the baffle 5280 may be disposed between the process processing unit 520 and the diffusion unit 560. Further, the baffle 5280 may be disposed between the support unit 5240 and the diffusion unit 560. The baffle 5280 may be disposed above the support unit 5240. In one example, the baffle 5280 may be disposed on the upper end of the process processing unit 520.

The baffle 5280 may uniformly deliver plasma generated by the plasma generation unit 540 into the processing space 5200. Baffle holes 5282 may be formed in the baffle 5280. The baffle holes 5282 may be provided in a plurality. The baffle holes 5282 may be spaced apart from each other. The baffle holes 5282 may penetrate the battle 5280 from the top end to the bottom end. The baffle holes 5282 may function as passageways for plasma generated in the plasma generation unit 540 to flow into the processing space 5200.

The baffle 5280 may have a plate shape. The baffle 5280 may have a disk shape when viewed from above. When viewed in cross-section, the baffle 5280 may have a height of its top surface that increases from an edge region to a center region. In one example, the baffle 5280 may have a shape such that its top surface slopes upwardly from the edge region to the center region when viewed in cross-section.

Accordingly, plasma generated by the plasma generation unit 540 may flow along the sloped cross-section of the baffle 5280 to the edge region of the processing space 5200. Unlike the examples described above, the cross-section of the baffle 5280 may not be provided to be sloped. In one example, the baffle 5280 may be provided in the shape of a disk having a predetermined thickness.

The plasma generation unit 540 may generate plasma by excitation of process gas supplied from the gas supply unit 5440, which will be described later, and supply the generated plasma into the processing space 5200.

The plasma generation unit 540 may be located above the process processing unit 520. The plasma generation unit 540 may be located above the housing 5220 and the diffusion section 560 which will be described later. The process processing unit 520, the diffusion unit 560, and the plasma generation unit 540 may be positioned sequentially from the ground along the third direction 6 perpendicular to both the first direction 2 and the second direction 4.

The plasma generation unit 540 may include a plasma chamber 5420, a gas supply unit 5440, and a plasma source 6000.

The plasma chamber 5420 may have a shape with an open upper surface and an open lower surface. For example, the plasma chamber 5420 may have a cylindrical shape with an open top surface and an open bottom surface. Openings may be formed in the top end and the bottom end of the plasma chamber 5420. The plasma chamber 5420 may have a plasma generation space 5422. The plasma chamber 5420 may be provided with a material including aluminum oxide (Al₂O₃).

The top surface of the plasma chamber 5420 may be sealed by a gas supply port 5424. The gas supply port 5424 may be connected to a gas supply unit 5440, which will be described later. Process gas may be supplied to the plasma generation space 5422 through the gas supply port 5424. The process gas supplied to the plasma generation space 5422 may be uniformly distributed through the baffle holes 5282 into the processing space 5200.

The gas supply unit 5440 may supply the process gas. The gas supply unit 5440 may be connected to the gas supply port 5424. For example, the process gas may include fluorine and/or hydrogen.

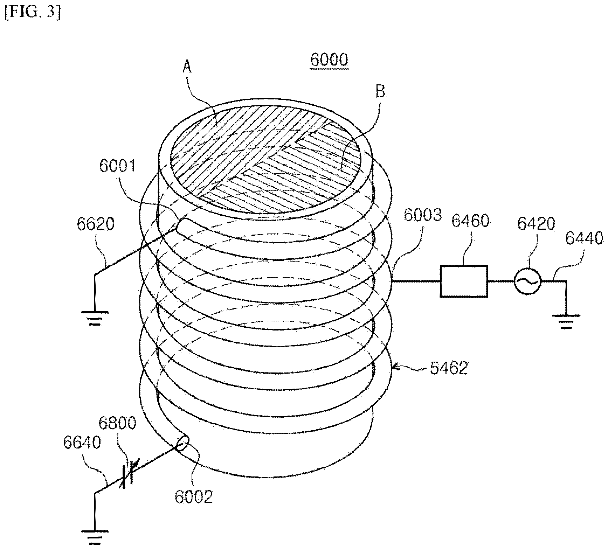

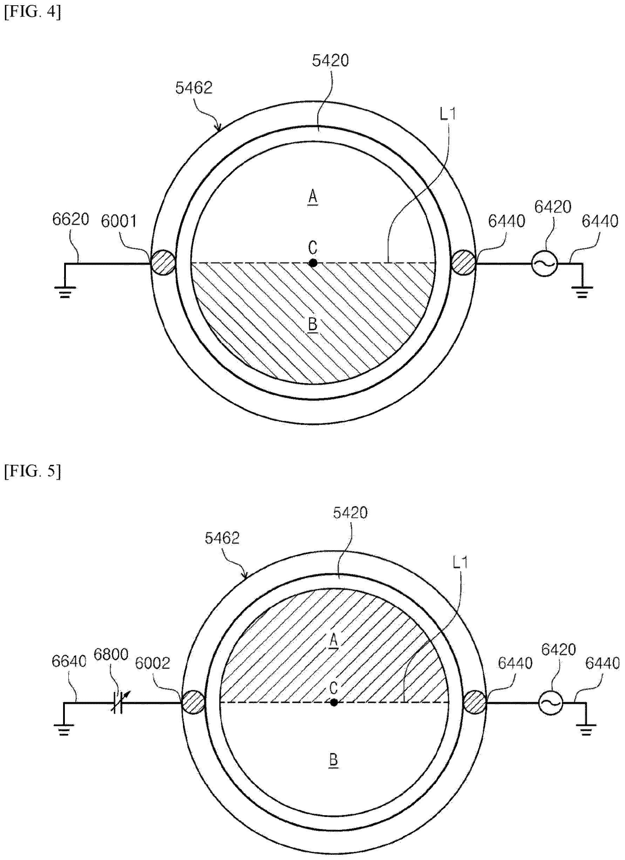

FIG. 3 is a diagram schematically illustrating a plasma source of FIG. 2. FIG. 4 is a diagram schematically illustrating the plasma source of FIG. 2 from a top view. FIG. 5 is a diagram schematically illustrating the plasma source of FIG. 2 from a bottom view. Hereinafter, a plasma source for the exemplary embodiment of the present invention will be described in detail with reference to FIGS. 2 to 5.

The plasma source 6000 excites the process gas supplied by the gas supply unit 5440 to a plasma state. The plasma source 6000 described in the exemplary embodiment of the present invention may be an Inductively Coupled Plasma (ICP) source. The plasma source 6000 may include an antenna 6200, a power application unit 6400, a first ground line 6620, a second ground line 6640, and a capacitor 6800.

The antenna 6200 may be an ICP antenna. The antenna 6200 may have a substantially circular shape when viewed from above. The antenna 6200 may have a coil wound with a plurality of turns. The antenna 6200 may be provided to wrap around the plasma chamber 5420 on an external portion of the plasma chamber 5420. The antenna 6200 may wrap around the plasma chamber 5420 in a region corresponding to the plasma generation space 5422. In one example, the antenna 6200 may have a coil wound a plurality of turns of the plasma chamber 5420 on an external portion of the plasma chamber 5420. The coil may receive high frequency power from the power source 6420, which will be described later, to induce a magnetic field in the plasma chamber 5420. Accordingly, the process gas supplied to the plasma generation space 5422 may be excited into plasma.

The coils configuring the antenna 6200 may be wound around the plasma chamber 5420 an odd number of turns. In one example, as illustrated in FIG. 3, the coil configuring the antenna 6200 may wind around the plasma chamber 5420 five times.

As illustrated in FIGS. 4 and 5, the coil may be provided in a circular shape when viewed from above. When viewed from above, one end of the coil and the other end of the coil may be provided in an overlapping position. One end of the coil may be provided at a height corresponding to an upper region of the plasma chamber 5420, as viewed from a right cross-sectional view of the plasma chamber 5420. The other end of the coil may be provided at a height corresponding to a lower region of the plasma chamber 5420, as viewed from a right cross-sectional view of the plasma chamber 5420. One end of the coil is connected to the first ground line 6620, which will be described later. The point where one end of the coil and the first ground line 6620 are connected may function as a first ground terminal 6001. The other end of the coil is connected to the second ground line 6640, which will be described later. The point where the other end of the coil is connected to the second ground line 6640 may function as a second ground terminal 6002.

The power application unit 6400 may include a power source 6420, a power line 6440, and a matcher 6460. The power source 6420 generates power. The power source 6420 may be a high frequency power source. For example, the power source 6420 may generate high frequency power. The power source 6420 may apply power to the antenna 6200 through the power line 6440, which will be described later. The power source 6420 may apply high frequency current to the antenna 6200 through the power line 6440. The high frequency current applied to the antenna 6200 may form an induced electric field in the plasma generation space 5422. The process gas supplied into the plasma generation space 5422 may obtain the energy required for ionization from the induced electric field and be converted to a plasma state.

The power line 6440 may deliver high frequency power generated by the power source 6420 to the antenna 6200. One end of the power line 6440 may be connected to the power source 6420. The other end of the power line 6440 may be connected between the one end and the other end of the coil. For example, the other end of the power line 6440 may be connected to a midpoint between the one end and the other end of the coil configuring the antenna 6200. The midpoint between the one end of the coil and the other end may function as a power application terminal 6003 that applies high frequency current to the antenna 6200. The high frequency current supplied through the power line 6440 may be distributed toward one end of the coil and the other end of the coil. The high frequency current supplied through the power line 6440 may be distributed to one end of the coil and the other end of the coil, with respect to the power application terminal 6003 connected to a midpoint of the coil.

The matcher 6460 may perform matching on high frequency power applied to the antenna 6200 from the power source 6420. The matcher 6460 may be connected to an output terminal of the power source 6420 to match output impedance and input impedance of the power source 6420. In one example, the matcher 6460 may be connected on the power line 6440 between the power source 6420 and the antenna 6200.

The first ground line 6620 may be connected to the antenna 6200. The first ground line 6620 may be connected to one end of the coil configuring the antenna 6200. The point where one end of the coil and the first ground line 6620 are connected may function as a first ground terminal 6001. Accordingly, one end of the coil may be connected to the first ground line 6620 and grounded.

The second ground line 6640 may be connected to the antenna 6200. The second ground line 6640 may be connected to the other end of the coil configuring the antenna 6200. The point where the other end of the coil is connected to the second ground line 6640 may function as a second ground terminal 6002. Accordingly, the other end of the coil may be connected to the second ground line 6640 and grounded.

The first ground terminal 6001 and the second ground terminal 6002 may be provided at an overlapping position when viewed from above. The first ground terminal 6001 and the power application terminal 6003 may be positioned opposite each other with respect to the plasma chamber 5420. The second ground terminal 6002 and the power application terminal 6003 may be positioned opposite each other with respect to the plasma chamber 5420. A virtual straight line L1 connecting the first ground terminal 6001 and the power application terminal 6003 may pass through the center C of the antenna 6200. Additionally, the virtual straight line L1 connecting the first ground terminal 6001 and the power application terminal 6003 may pass through the center C of the coil.

Hereinafter, the upper portion of the virtual straight line L1 connecting the first ground terminal 6001 and the power application terminal 6003 in the region where the coil is wound around the plasma chamber 6420, as viewed from above, is defined as an upper region A. Further, the lower portion of the virtual straight line L1 connecting the first ground terminal 6001 and the power application terminal 6003 in the region where the coil is wound around the plasma chamber 5420, as viewed from above, is defined as a lower region B.

The capacitor 6800 may be a variable element. The capacitor 6800 may be provided in any one of the first ground line 6620 and the second ground line 6640. The capacitor 6800 according to the exemplary embodiment may be provided as a variable capacitor with changing capacitance. However, the present invention is not limited thereto, and the capacitor 6800 according to the exemplary embodiment may be provided as a fixed capacitor with fixed capacitance. If the capacitor 6800 is provided as a fixed capacitor, the capacitor 6800 may be provided as a capacitor of various capacitance depending on the type of process and the requirements of the process. However, for ease of explanation, hereinafter, the present invention will be described based on the case where the capacitor 6800 is provided as a variable capacitor 6800 as an example.

The capacitor 6800 may determine a distribution ratio of the high frequency current distributed to one end of the coil and the other end of the coil for the high frequency current supplied from the power application terminal 6003. The capacitor 6800 may change the capacitance thereof to change the distribution ratio of the high frequency current distributed to one end of the coil and the other end of the coil. In one example, the magnitude of the first current applied to one end of the coil from the power application terminal 6003 and the magnitude of the second current applied to the other end of the coil from the power application terminal 6003 may be determined by the capacitance of the capacitor 6800.

According to the exemplary embodiment of the present invention, when viewing the plasma chamber 5420 in a right cross-sectional view, the number of coils wound in the lower region B in the upper region of the plasma chamber 5420 may be greater than the number of coils wound in the upper region A. Accordingly, in the upper region of the plasma chamber 5420, the density of the plasma formed in the lower region B may be adjusted to be relatively greater than the density of the plasma formed in the upper region A, with respect to the power application terminal 6003, as illustrated in FIG. 4. Further, with respect to the power application terminal 6003, as illustrated in FIG. 5, in the lower region of the plasma chamber 5420, the density of the plasma formed in the upper region A may be relatively greater than the density of the plasma formed in the lower region B. Accordingly, by winding the coil around the plasma chamber 5420 with an odd number of turns, the density of plasma formation may be finely adjusted by varying the density of plasma formed in the upper region A and the lower region B depending on the regions of the plasma chamber 5420 in the upward and downward directions.

Also, as illustrated in FIG. 3, the capacitor 6800 may be provided on the second ground line 6640. However, the present invention is not limited thereto, and the capacitor 6800 may also be provided on the first ground line 6620. Hereinafter, for ease of description, the present invention will be described based on the case where the capacitor 6800 is provided on the second ground line 6640 as an example.

When the capacitance of the capacitor 6800 is changed from a first magnitude to a second magnitude that is less than the first magnitude, the second current distributed from the power application terminal 6003 to the second ground terminal 6002 may be relatively low. Also, when the capacitance of the capacitor 6800 is changed from a third magnitude to a fourth magnitude that is greater than the third magnitude, the second current distributed from the power application terminal 6003 to the second ground terminal 6002 may be relatively large. Accordingly, the ratio of the first current distributed from the power application terminal 6003 to the first ground terminal 6001 and the second current distributed from the power application terminal 6003 to the second ground terminal 6002 may be changed. By changing the ratio of the currents distributed to the one end and the other end of the coil, the magnitude of the electric field formed along the up and down direction of the plasma chamber 5420 may be changed. Accordingly, the density and/or the magnitude of the plasma generated in the plasma generation space 5422 may be changed.

Referring again to FIG. 2, the diffusion unit 560 may diffuse the plasma generated in the plasma generation unit 540 into the processing space 5200. The diffusion unit 560 may include a diffusion chamber 5620. The diffusion chamber 5620 includes a plasma diffusion space 5622 for diffusing the plasma generated in the plasma chamber 5420. The plasma generated in the plasma generation unit 540 may be diffused as it passes through the plasma diffusion space 5622. The plasma entering the plasma diffusion space 5622 may be uniformly distributed through the baffle 5280 and into the processing space 5200.

The diffusion chamber 5620 may be located below the plasma chamber 5420. The diffusion chamber 5620 may be located between the housing 5220 and the plasma chamber 5420. The housing 5220, the diffusion chamber 5620, and the plasma chamber 5420 may be positioned sequentially from the ground along the third direction 6. The inner circumferential surface of the diffusion chamber 5620 may be provided as a non-conductor. In one example, the inner circumferential surface of the diffusion chamber 5620 may be provided with a material including quartz.

The exhaust unit 580 may exhaust process gases and impurities inside the processing unit 520 to the outside. The exhaust unit 580 may exhaust impurities, particles, and the like generated during the process of processing the substrate W to the outside of the process chamber 500. The exhaust unit 580 may exhaust process gas supplied into the processing space 5200 to the outside of the process chamber 500. The exhaust unit 580 may include an exhaust line 5820 and a pressure reducing member 5840. The exhaust line 5820 may be connected to the exhaust holes 5222 formed in the bottom surface of the housing 5220. The exhaust line 5820 may be connected with the pressure reducing member 5840 to provide pressure reduction.

The pressure reducing member 5840 may provide negative pressure to the processing space 5200. The pressure reducing member 5840 may discharge plasma, impurities, particles, and the like that remain in the processing space 5200 to the outside of the housing 5220. Additionally, the pressure reducing member 5840 may provide negative pressure to maintain the pressure in the processing space 5200 at a predetermined pressure. The pressure reducing member 123 may be a pump. However, the pressure reducing member 5840 is not limited thereto, and may be provided with various variations of known devices that provide negative pressure.

Hereinafter, a substrate processing method according to an exemplary embodiment of the present invention will be described in detail. The substrate processing method described below may be performed by the process chamber 500 described above. Further, the controller 40 may control configurations of the process chamber 500 such that the process chamber 500 may perform the substrate processing method described below. For example, the controller 40 may generate control signals to control at least one of the power source 6420 and the capacitor 6800 to enable the configurations of the process chamber 500 to perform the substrate processing method described below.

A substrate processing method according to an exemplary embodiment of the present invention may include a substrate loading operation S10, a substrate processing operation S20, and a substrate unloading operation S30. The substrate loading operation S10 is an operation for loading the substrate W into the process chamber 500. In the substrate loading operation S10, the substrate W enters and exits the interior of the housing 5220 through an opening (not illustrated) formed in a lateral wall of the housing 5220. The substrate W entering the interior of the housing 520 may be seated on the support unit 5240. The substrate W seated on the support unit 5240 may be fixedly supported on the support unit 5240 by electrostatic forces.

The substrate processing operation S20 is an operation of performing predetermined processing on the substrate W loaded into the process chamber 500 by using plasma. In one example, the substrate processing operation S20 may include etching or ashing a thin film on the substrate W. In the substrate processing operation S20, plasma is generated in the plasma generation unit 540. For example, in the substrate processing operation S20, process gas may be supplied to the plasma generation space 5422 by the gas supply unit 5440 and a high frequency current may be applied to the antenna 6200. The high frequency current applied to the antenna 6200 may generate a magnetic field in the plasma generation space 5422. The magnetic field formed in the plasma generation space 5422 may excite the process gas flowing through the plasma generation space 5422.

In the substrate processing operation S20, a high frequency current may be applied directly to the coil through the power application terminal 6003 connected between one end and the other end of the coil configuring the antenna 6200. In the exemplary embodiment of the present invention, the power application terminal 6003 may be connected at an intermediate location between one end of the coil and the other end of the coil. The high frequency current applied from the power application terminal 6003 connected to the coil may be distributed as a first current toward one end of the coil and a second current toward the other end of the coil. In other words, the high frequency current supplied from the power application terminal 6003 may be distributed as a first current toward the first ground terminal 6001 and a second current toward the second ground terminal 6002 with respect to the power application terminal 6003.

The distribution ratio of the first current and the second current may be determined by the capacitor 6800 connected to the first ground line 6620 or the second ground line 6640. In one example, the capacitor 6800 may be connected to the second ground line 6640. When the capacitance of the capacitor 6800 is changed from a first magnitude to a second magnitude that is smaller than the first magnitude, the magnitude of the second current toward the other end of the coil may decrease. Conversely, when the capacitance of the capacitor 6800 is changed from a third magnitude to a fourth magnitude that is larger than the third magnitude, the magnitude of the second current toward the other end of the coil may increase. As a result, the ratio of the first current toward one end of the coil to the second current toward the other end of the coil may be changed. This may change the magnitude of the electric field formed along the up and down direction of the plasma chamber 5420. Accordingly, the density and/or the magnitude of the plasma generated in the plasma generation space 5422 may be changed.

Further, the coil configuring the antenna 6200 according to the exemplary embodiment of the present invention may be wound an odd number of times around the plasma chamber 5420 from the external side of the plasma chamber 5420. Further, the one end and the other end of the coil configuring the antenna 6200 according to the exemplary embodiment of the present invention may be positioned to overlap when viewed from above.

Accordingly, with respect to the power application terminal 6003, in the upper region of the plasma chamber 5420, a plasma density of a first magnitude formed in the upper region A may be relatively smaller than a plasma density of a second magnitude formed in the lower region B. Further, with respect to the power application terminal 6003, in the lower region of the plasma chamber 5420, a plasma density of a third magnitude formed in the upper region A may be relatively larger than a plasma density of a fourth magnitude formed in the lower region B. Accordingly, the density of plasma formation may be fine-tuned by varying the density of plasma formed in the upper region A and the density of plasma formed in the lower region B depending on the region in the up and down direction of the plasma chamber 5420.

The substrate unloading operation S30 is an operation of unloading the substrate W that has been processed in the substrate processing operation S20 is unloaded to the outside of the process chamber 500. In the substrate unloading operation S30, the substrate W is unloaded to the outside of the housing 5220 through an opening (not illustrated) formed in a lateral wall of the housing 5220.

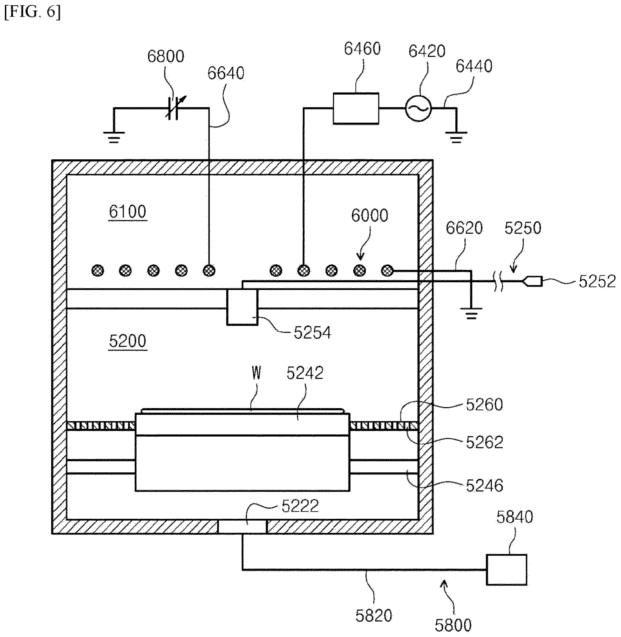

FIG. 6 is a diagram schematically illustrating a process chamber performs a plasma treatment process among the process chambers of the substrate processing apparatus of FIG. 1 according to another exemplary embodiment. The substrate processing apparatus according to the exemplary embodiment of the present invention described hereinafter is provided similarly to the substrate processing apparatus described with reference to FIGS. 1 to 5 with the exception of the process chamber 500, so that the descriptions of the redundant contents will be omitted. Hereinafter, a substrate processing apparatus according to another exemplary embodiment of the present invention will be described in detail with reference to FIG. 6.

The process chamber 500 according to the exemplary embodiment of the present invention performs a predetermined process on the substrate W by using plasma. In one example, a thin film on the substrate W may be etched or ashed. The thin film may be various types of films, such as a polysilicon film, an oxide film, or a silicon nitride film. Optionally, the thin film may be a natural oxide film or a chemically generated oxide film.

The process chamber 500 may include a housing 5220, a window unit 5230, a support unit 5240, a gas supply unit 5250, an exhaust unit 5800, and a plasma source 6000.

The housing 5220 may have a processing space 5200 where the substrate W is processed and an upper space 6100. The housing 5220 may be provided of a metal material. The housing 5220 may be provided of a material including aluminum. The housing 5220 may be grounded. The housing 5220 may include a lower body 5224 and an upper body 5226.

The lower body 5224 may have a space with an open top surface therein. In one example, the lower body 5224 may have the shape of a barrel with an open top. The lower body 5224 may be combined with a window unit 5230, which will be described later, to have a processing space 5200 therein. The lower body 5224 and the window unit 5230 may be combined with each other to be defined as a process processing unit providing the processing space 5200 for processing the substrate W.

The upper body 5226 may have a space with an open bottom therein. For example, the upper body 5226 may have the shape of a barrel with an open bottom. The upper body 5226 may be combined with the window unit 5230, which will be described later, to have an upper space 6100 therein. An opening (not illustrated) may be formed in a lateral of the lower body 5224. The substrate W enters and exits the interior of the housing 110 through the opening. The opening (not illustrated) may be opened and closed by an opening/closing member, such as a door (not illustrated).

The window unit 520 may be disposed above the lower body 5224. The window unit 5230 may cover an open top surface of the lower body 5224. The window unit 5230 may be combined with the lower body 5120 to form the processing space 5200. The window unit 5230 may be disposed on a lower portion of the upper body 5226 to cover an open bottom side of the upper body 5226. The window unit 5230 may be combined with the upper body 5226 to form the upper space 6100.

The upper space 6100 may be provided above the processing space 5200. The processing space 5200 may function as a space where the substrate W is supported by the support unit 5240, which will be described later, and where the substrate W is processed. The upper space 6100 may function as a space in which the plasma source 6000, which will be described later, is disposed.

The window unit 5230 may be provided in a plate shape. The window unit 5230 may seal the processing space 5200. The window unit 5220 may include a dielectric substance window. An opening may be formed in the window unit 5230. In one example, an opening may be formed in the center of the window unit 5230. In the opening formed in the window unit 5230, a gas supply nozzle 5254, which will be described later, may be installed. The gas supply nozzle installed in the window unit 5230 may be detachably provided.

The support unit 5240 supports the substrate W in the processing space 5200. The support unit 5240 may include a support plate 5242. The support plate 5242 may be provided as an electrostatic chuck. In one example, the support plate 5242 may be connected to an external power source. The support plate 5242 may generate static electricity by power applied from the external power source. The electrostatic force of the generated static electricity may hold the substrate W to the support unit 5240. The support plate 5242 may be located while being spaced apart from the housing 5220 by a connection member 5246. The connection member 5246 may connect the housing 5220 and the support plate 5242. The connecting member 5246 may be installed between an inner wall of the housing 5220 and the support plate 5242.

The gas supply unit 5250 may supply process gas to the processing space 5200. The process gas supplied by the gas supply unit 5250 to the processing space 5200 may include fluorine and/or hydrogen. However, the present invention is not limited thereto, and the type of process gas supplied by the gas supply unit 5250 to the processing space 5200 may be variously modified to any known process gas.

The gas supply unit 5250 may include a gas supply source 5252 and a gas supply nozzle 5254. The gas supply source 5252 may store process gas, or may deliver process gas to the gas supply nozzle 5254. The gas supply nozzle 5254 supplies process gas to the processing space 5200. The gas supply nozzle 5254 may supply process gas received from the gas supply source 5252 to the processing space 5200. The gas supply nozzle 5254 may be installed on the window unit 5230. In one example, the gas supply nozzle 5254 may be installed in an opening formed in the center of the window unit 5230.

The exhaust baffle 5260 uniformly exhausts plasma from the processing space 5200 for each region. When viewed from above, the exhaust baffle 300 has an annular ring shape. The exhaust baffle 5260 may be positioned between the inner wall of the housing 5220 and the support plate 5242 within the processing space 5200.

A plurality of exhaust holes 5262 is formed in the exhaust baffle 5260. The exhaust holes 5262 may be provided to face in an upward or downward direction. The exhaust holes 5262 may be provided as holes extending from a top end to a bottom end of the exhaust baffle 5260. The exhaust holes 5262 may be arranged to be spaced apart from each other along the circumferential direction of the exhaust baffle 5260.

The exhaust unit 5800 may exhaust process gases and impurities inside the processing space 5200 to the outside. The exhaust unit 5800 may exhaust impurities and particles generated in the process of processing the substrate W to the outside of the process chamber 500. The exhaust unit 5800 may exhaust process gas supplied into the processing space 5200 to the outside of the process chamber 500. The exhaust unit 5800 may include an exhaust line 5820 and a pressure reducing member 5840. The exhaust line 5820 may be connected to the exhaust holes 5222 formed in the bottom surface of the housing 5220. The exhaust line 5820 may be connected to an exhaust hole 5222 formed in a bottom surface of the housing 5220. The exhaust line 5820 may be connected with the pressure reducing member 5840 to provide pressure reduction.

The pressure reducing member 5840 may provide negative pressure to the processing space 5200. The pressure reducing member 5840 may discharge plasma, impurities, particles, and the like that remain in the processing space 5200 to the outside of the housing 5220. Additionally, the pressure reducing member 5840 may provide negative pressure to maintain the pressure in the processing space 5200 at a predetermined pressure. The pressure reducing member 123 may be a pump. However, the pressure reducing member 5840 is not limited thereto, and may be provided with various variations of known devices that provide negative pressure.

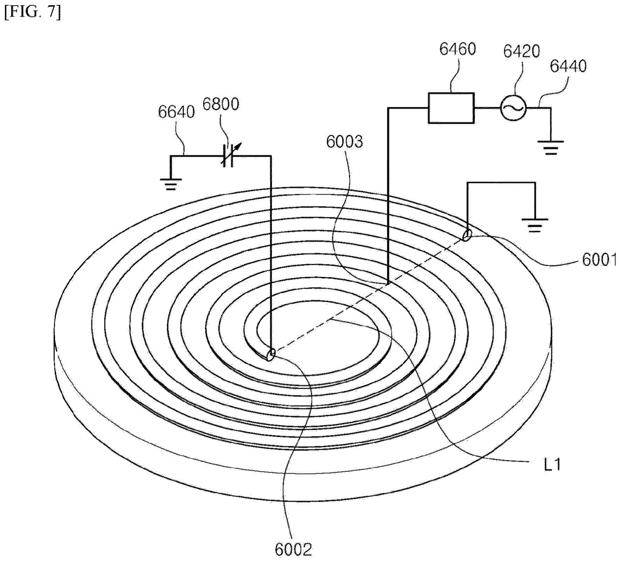

FIG. 7 is a perspective view schematically illustrating the plasma source of FIG. 6. Hereinafter, a plasma source according to the exemplary embodiment of the present invention will be described in detail with reference to FIGS. 6 and 7.

The plasma source 6000 excites process gas supplied from the gas supply unit 5250 to a plasma state. In one example, the plasma source 6000 may excite process gas supplied to the processing space 5200 to generate plasma in the processing space 5200. The plasma source 6000 described in the exemplary embodiment of the present invention may be an Inductively Coupled Plasma (ICP) source. The plasma source 6000 may include an antenna 6200, a power application unit 6400, a first ground line 6620, a second ground line 6640, and a capacitor 6800.

The antenna 6200 may be provided as an Inductively Coupled Plasma (ICP) antenna. The antenna 6200 may be located at the top of the process processing unit where the lower body 5224 and the window unit 5230 are combined with each other to provide the processing space 5200 for processing the substrate W. In one example, the antenna 6200 may be located in the upper space 6100. Additionally, the antenna 6200 may be located on a plane within the upper space 6100. The antenna 6200 may be provided in a spiral shape, when viewed from above. The antenna 6200 may be positioned to face the support unit 5240 when viewed from above. The antenna 6200 may be provided in a position opposite the substrate W supported on the support unit 5240 in the processing space 5200, when viewed from above. The antenna 6200, according to the exemplary embodiment of the present invention, may have a single output terminal.

The antenna 6200 may have a coil wound with a plurality of turns. The coil may receive high frequency power from the power source 6420, which will be described later, to induce a magnetic field in the processing space 5200. Accordingly, process gas supplied to the processing space 5200 may be excited into plasma.

One end of the coil and the other end of the coil may be positioned opposite each other when viewed from above. In one example, a virtual straight line L1 connecting one end of the coil to the other end of the coil may pass through a center C of the antenna 6200. The virtual straight line L1 connecting one end of the coil to the other end of the coil may pass through the center C wound multiple times.

One end of the coil is connected to the first ground line 6620, which will be described later. The point where one end of the coil and the first ground line 6620 are connected may function as a first ground terminal 6001. The other end of the coil is connected to the second ground line 6640, which will be described later. The point where the other end of the coil is connected to the second ground line 6640 may function as a second ground terminal 6002. The virtual straight line L 1 connecting the first ground terminal 6001 connected to one end of the coil and the second ground terminal 6002 connected to the other end of the coil may pass through the center C of the coil wound multiple times.

The power application unit 6400 may include a power source 6420, a power line 6440, and a matcher 6460. The power source 6420 generates power. The power source 6420 may be a high frequency power source. For example, the power source 6420 may generate high frequency power. The power source 6420 may apply power to the antenna 6200 through the power line 6440, which will be described later. The power source 6420 may apply high frequency current to the antenna 6200 through the power line 6440. The high frequency current applied to the antenna 6200 may form an induced electric field in the plasma generation space 5422. The process gas supplied into the plasma generation space 5422 may obtain the energy required for ionization from the induced electric field and be converted to a plasma state.

The power line 6440 may deliver high frequency power generated by the power source 6420 to the antenna 6200. One end of the power line 6440 may be connected to the power source 6420. The other end of the power line 6440 may be connected between the one end and the other end of the coil. The point where the coil is connected to the power line may function as a power application terminal 6003 that applies high frequency current to the antenna 6200. The high frequency current supplied through the power line 6440 may be distributed toward one end of the coil and the other end of the coil. The high frequency current supplied through the power line 6440 may be distributed to one end of the coil and the other end of the coil, with respect to the power application terminal 6003.

The matcher 6460 may perform matching on high frequency power applied to the antenna 6200 from the power source 6420. The matcher 6460 may be connected to an output terminal of the power source 6420 to match output impedance and input impedance of the power source 6420. In one example, the matcher 6460 may be connected on the power line 6440 between the power source 6420 and the antenna 6200.

The first ground line 6620 may be connected to the antenna 6200. The first ground line 6620 may be connected to one end of the coil configuring the antenna 6200. The point where one end of the coil and the first ground line 6620 are connected may function as a first ground terminal 6001. Accordingly, one end of the coil may be connected to the first ground line 6620 and grounded.

The second ground line 6640 may be connected to the antenna 6200. The second ground line 6640 may be connected to the other end of the coil configuring the antenna 6200. The point where the other end of the coil is connected to the second ground line 6640 may function as a second ground terminal 6002. Accordingly, the other end of the coil may be connected to the second ground line 6640 and grounded.

The first ground terminal 6001 and the second ground terminal 6002 may be provided in positions opposite each other when viewed from above. Accordingly, the virtual straight line L1 connecting the first ground terminal 6001 and the second ground terminal 6002 may pass through the center C of the coil.

The capacitor 6800 may be a variable element. The capacitor 6800 may be provided in any one of the first ground line 6620 and the second ground line 6640. The capacitor 6800 according to the exemplary embodiment may be provided as a variable capacitor with changing capacitance. However, the present invention is not limited thereto, and the capacitor 6800 according to the exemplary embodiment may be provided as a fixed capacitor with fixed capacitance. If the capacitor 6800 is provided as a fixed capacitor, the capacitor 6800 may be provided as a capacitor of various capacitance depending on the type of process and the requirements of the process. However, for ease of explanation, hereinafter, the present invention will be described based on the case where the capacitor 6800 is provided as a variable capacitor 6800 as an example.

The capacitor 6800 may determine a distribution ratio of the high frequency current distributed to one end of the coil and the other end of the coil for the high frequency current supplied from the power application terminal 6003. The capacitor 6800 may change the capacitance thereof to change the distribution ratio of the high frequency current distributed to one end of the coil and the other end of the coil. In one example, the magnitude of the first current applied to one end of the coil from the power application terminal 6003 and the magnitude of the second current applied to the other end of the coil from the power application terminal 6003 may be determined by the capacitance of the capacitor 6800.

As illustrated in FIG. 7, the capacitor 6800 may be provided on the second ground line 6640. However, the present invention is not limited thereto, and the capacitor 6800 may also be connected to the first ground line 6620. When the capacitance of the capacitor 6800 is changed from a first magnitude to a second magnitude that is less than the first magnitude, the second current distributed from the power application terminal 6003 to the second ground terminal 6002 may be relatively low.

Also, when the capacitance of the capacitor 6800 is changed from a third magnitude to a fourth magnitude that is greater than the third magnitude, the second current distributed from the power application terminal 6003 to the second ground terminal 6002 may be relatively large. Accordingly, the ratio of the first current distributed from the power application terminal 6003 to the first ground terminal 6001 and the second current distributed from the power application terminal 6003 to the second ground terminal 6002 may be changed.

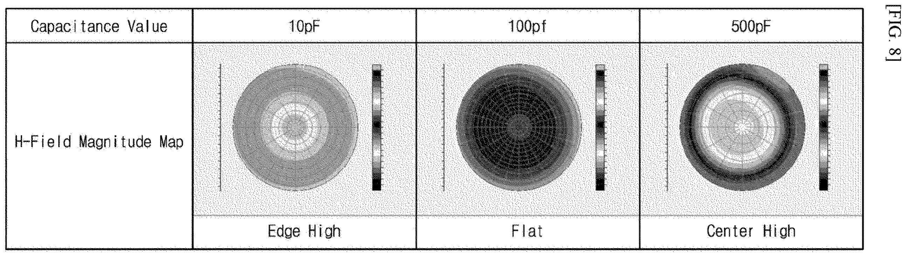

FIG. 8 is a diagram schematically illustrating a magnetic field distribution inside the chamber according to a value of a capacitor of FIG. 6. Referring to FIG. 8, capacitance of the capacitor 6800 may have a first magnitude of 10 pF, a second magnitude of 100 pF, and a third magnitude of 500 pF. When the capacitance of the capacitor 6800 is changed from the first magnitude to the third magnitude, the magnitude of the second current distributed from the power application terminal 6003 to the second ground terminal 6002 increases. Accordingly, the magnitude of the magnetic field generated from the second current supplied to the second ground terminal 6002 from the power application terminal 6003 increases. In one example, the coil from the power application terminal 6003 to the second ground terminal 6002 may be positioned opposite the center region of the processing space 5200. Accordingly, when the capacitance of the capacitor 6800 is changed from the first magnitude to the third magnitude, magnetic field strength in the central region of the processing space 5200 may be formed large.

Also, when the capacitance of the capacitor 6800 is changed from the third magnitude to the first magnitude, the magnitude of the second current distributed from the power application terminal 6003 to the second ground terminal 6002 decreases. Accordingly, the magnitude of the current distributed to the first current is relatively increased. Accordingly, the magnitude of the magnetic field generated by the second current supplied from the power application terminal 6003 to the second ground terminal 6002 decreases. Further, the magnitude of the magnetic field generated by the first current supplied from the power application terminal 6003 to the first ground terminal 6001 increases. Accordingly, when the capacitance of the capacitor 6800 is changed from the third magnitude to the first magnitude, magnetic field intensity in the edge region may be formed greater than that in the center region of the processing space 5200. Accordingly, the capacitance of the capacitor 6800 may be varied based on process requirements, thereby changing the density and/or the magnitude of the plasma generated within the processing space 5200. Furthermore, according to the exemplary embodiment of the present invention, by connecting the power application terminal 6800 to a specific point between one end and the other end of the coil, the distribution points of the first current and the second current distributed with respect to the power application terminal 6800 may be determined. Thus, the density of the plasma may be easily controlled according to process requirements.

Hereinafter, a substrate processing method according to an exemplary embodiment of the present invention described with reference to FIGS. 6 to 8 will be described in detail. The substrate processing method described below may be performed by the process chamber 500 described above. Further, the controller 40 may control configurations of the process chamber 500 such that the process chamber 500 may perform the substrate processing method described below. For example, the controller 40 may generate control signals to control at least one of the power source 6420 and the capacitor 6800 to enable the configurations of the process chamber 500 to perform the substrate processing method described below.

A substrate processing method according to an exemplary embodiment of the present invention may include a substrate loading operation S10, a substrate processing operation S20, and a substrate unloading operation S30. The substrate loading operation S10 is an operation for loading the substrate W into the process chamber 500. In the substrate loading operation S10, the substrate W enters and exits the interior of the housing 5220 through an opening (not illustrated) formed in a lateral wall of the housing 5220. The substrate W entering the interior of the housing 520 may be seated on the support unit 5240. The substrate W seated on the support unit 5240 may be fixedly supported on the support unit 5240 by electrostatic forces.

The substrate processing operation S20 is an operation of performing predetermined processing on the substrate W loaded into the process chamber 500 by using plasma. In one example, the substrate processing operation S20 may include etching or ashing a thin film on the substrate W. In the substrate processing operation S20, plasma is generated in the processing space 5200. For example, in the substrate processing operation S20, process gas may be supplied to the processing space 5200 by the gas supply unit 5250 and high frequency current may be applied to the antenna 6200. The high frequency current applied to the antenna 6200 may generate a magnetic field in the processing space 5200. The magnetic field formed in the processing space 5200 may excite process gas flowing through the processing space 5200.

In the substrate processing operation S20, a high frequency current may be applied directly to the coil through the power application terminal 6003 connected between one end and the other end of the coil configuring the antenna 6200. In the exemplary embodiment of the present invention, the power application terminal 6003 may be connected between one end of the coil and the other end of the coil. The high frequency current applied from the power application terminal 6003 connected to the coil may be distributed as a first current toward one end of the coil and a second current toward the other end of the coil. In other words, the high frequency current supplied from the power application terminal 6003 may be distributed as a first current toward the first ground terminal 6001 and a second current toward the second ground terminal 6002 with respect to the power application terminal 6003.

A region of the processing space 5200 opposite one end of the coil from the power application terminal 6003 may have a plasma density of a first magnitude from the first current. A region of the processing space 5200 opposite the other end of the coil from the power application terminal 6003 may have a plasma density of a second magnitude from the second current.

The distribution ratio of the first current and the second current may be determined by the capacitor 6800 connected to the first ground line 6620 or the second ground line 6640. In one example, the capacitor 6800 may be connected to the second ground line 6640. However, the present invention is not limited thereto, and the capacitor 6800 may also be connected to the first ground line 6620. When the capacitance of the capacitor 6800 is changed from the first magnitude to the second magnitude that is smaller than the first magnitude, the magnitude of the second current distributed from the power application terminal 6003 to the second ground terminal 6002 decreases. Accordingly, the magnitude of the current distributed to the first current is relatively increased. Accordingly, the magnitude of the magnetic field generated by the second current supplied from the power application terminal 6003 to the second ground terminal 6002 decreases. Further, the magnitude of the magnetic field generated by the first current supplied from the power application terminal 6003 to the first ground terminal 6001 increases. Accordingly, the region of the processing space 5200 opposite the one end of the coil from the power application terminal 6003 may have the plasma density of the first magnitude. In addition, the region of the processing space 5200 opposite the other end of the coil from the power application terminal 6003 may have the plasma density of the second magnitude that is smaller than the first magnitude. When the capacitance of the capacitor 6800 is changed from the third magnitude to the first magnitude, the magnetic field and the plasma density in the edge region may be formed to be greater than in the center region of the processing space 5200.

Conversely, when the capacitance of the capacitor 6800 is changed from the third magnitude to the fourth magnitude that is greater than the third magnitude, the magnitude of the second current distributed from the power application terminal 6003 to the second ground terminal 6002 is increased. Accordingly, the magnitude of the magnetic field generated from the second current supplied to the second ground terminal 6002 from the power application terminal 6003 also increases. In one example, the coil from the power application terminal 6003 to the second ground terminal 6002 may be positioned opposite the center region of the processing space 5200. Accordingly, when the capacitance of the capacitor 6800 is changed from the first magnitude to the third magnitude, magnetic field strength in the central region of the processing space 5200 may be formed large.

Accordingly, the capacitance of the capacitor 6800 may be varied based on process requirements, thereby changing the density and/or the magnitude of the plasma generated within the processing space 5200. Furthermore, according to the exemplary embodiment of the present invention, by connecting the power application terminal 6800 to a specific point between one end and the other end of the coil, the distribution points of the first current and the second current distributed with respect to the power application terminal 6800 may be determined. Thus, the density of the plasma may be easily controlled according to process requirements.

The foregoing detailed description illustrates the present invention. Further, the above content illustrates and describes the exemplary embodiment of the present invention, and the present invention may be used in various other combinations, modifications, and environments. That is, the foregoing content may be modified or corrected within the scope of the concept of the invention disclosed in the present specification, the scope equivalent to that of the invention, and/or the scope of the skill or knowledge in the art. The foregoing exemplary embodiment describes the best state for implementing the technical spirit of the present invention, and various changes required in the specific application field and use of the present invention are possible. Accordingly, the detailed description of the invention above is not intended to limit the invention to the disclosed exemplary embodiment. Further, the accompanying claims should be construed to include other exemplary embodiments as well.

## Claims

1. An apparatus for processing a substrate, the apparatus comprising:
a process processing unit providing a processing space in which a substrate is processed; and
a plasma source for generating plasma from process gas,
wherein the plasma source includes:
an antenna including a coil wound with a plurality of turns; and
a power application unit for applying high frequency power to the coil, and
a first ground line is connected to one end of the coil,
a second ground line is connected to the other end of the coil, and
the power application unit is connected to the coil to apply high frequency power directly to the coil at a location between the one end of the coil and the other end of the coil.

2. The apparatus of claim 1, wherein the first ground line or the second ground line are provided with a capacitor.

3. The apparatus of claim 2, wherein the capacitor is a variable capacitor,
the apparatus further comprises a controller controlling the capacitor, and
the controller controls the capacitor to adjust a ratio of power distributed to the first ground line and the second ground line by changing capacitance of the capacitor.

4. The apparatus of claim 3, further comprising:
a plasma chamber having a generating space in which the plasma is generated above the process processing unit,
wherein the antenna includes the coil wound around the plasma chamber with a plurality of turns on an external portion of the plasma chamber, and
the coil is wound around the plasma chamber with an odd number of turns.

5. The apparatus of claim 4, wherein the coil is provided in a circular shape when viewed from above, and
the one end of the coil and the other end of the coil are provided in an overlapping position when viewed from above.

6. The apparatus of claim 5, wherein the power application unit includes a power source generating the high frequency power and a power line delivering the high frequency power generated by the power source,
the power line is connected at an intermediate position between the one end of the coil and the other end of the coil, and
when viewed from above, a virtual straight line connecting a first ground terminal in which the first ground line is connected to the coil and the power application terminal in which the power line is connected to the coil passes through a center of the coil.

7. The apparatus of claim 3, wherein the antenna is located above the process processing unit, and is provided in a spiral shape on a plane.

8. The apparatus of claim 7, wherein a virtual straight line connecting one end of the coil to the other end of the coil passes through a center of the coil.

9. The apparatus of claim 8, wherein the power application unit includes a power source generating the high frequency power and a power line delivering the high frequency power generated by the power source, and
the power line is connected between one end of the coil and the other end of the coil.

10. The apparatus of claim 9, wherein the antenna is located to face a support unit supporting a substrate in the processing space, when viewed from above.

11. The apparatus of claim 2, wherein the capacitor is provided as a fixed capacitor.

12. A method of processing a substrate, the method comprising:
generating plasma from process gas by applying a high frequency current directly to a coil through a power application terminal located between one end and the other end of the coil wound with a plurality of turns,
wherein the high frequency current is divided into a first current from the power application terminal toward the one end of the coil and a second current from the power application terminal toward the other end of the coil, and a distribution ratio of the first current and the second current is determined by a capacitor provided at one end of the coil or at the other end of the coil.

13. The method of claim 12, wherein a current ratio of the first current and the second current is adjusted by changing capacitance of the capacitor.

14. The method of claim 13, wherein the coil is wound around the plasma chamber with an odd number of turns and wrapped around the plasma chamber on an external portion of the plasma chamber having a generating space in which the plasma is generated, and is provided in a circular shape when viewed from above,
the one end of the coil and the other end of the coil are provided in an overlapping position, when viewed from above, and
the power application terminal is located in an intermediate position between the one end of the coil and the other end of the coil.

15. The method of claim 14, wherein when viewed from above, a half region based on an arbitrary straight line passing through a center of a substrate has a plasma density of a first magnitude, and the remaining region of the half region has a plasma density of a second magnitude.

16. The method of claim 13, wherein the coil is provided in a spiral shape in a plane, and a virtual straight line connecting the one end of the coil with the other end of the coil passes through a center of the coil.

17. The method of claim 16, wherein a location where the power application terminal is connected to the coil is changed.

18. The method of claim 17, wherein in a region opposite the one end of the coil from the power application terminal, a plasma density of a first magnitude is formed from the first current, and in a region opposite the other end of the coil from the power application terminal, a plasma density of a second magnitude is formed from the second current.
